Europäisches Patentamt

European Patent Office

Office européen des brevets

(11) Publication number: **0 503 154 A2**

# EUROPEAN PATENT APPLICATION

(21) Application number: **91121850.1**

(22) Date of filing: **19.12.91**

(51) Int. Cl.5: **H04H 1/00**

(30) Priority: **14.03.91 JP 49560/91**

(43) Date of publication of application:
**16.09.92 Bulletin 92/38**

(84) Designated Contracting States:
**DE FR GB**

(71) Applicant: **PIONEER ELECTRONIC CORPORATION**
**No. 4-1, Meguro 1-chome**
**Meguro-ku Tokyo 153(JP)**

(72) Inventor: **Nagashima, Akira, c/o Pioneer Electronic Corp.**
**Kawagoe Kojo, 25-1, Aza Nishimachi**
**Oaza Yamada, Kawagoe-shi, Saitama, 350(JP)**

(74) Representative: **Reinhard, Skuhra, Weise**
**Friedrichstrasse 31**
**W-8000 München 40(DE)**

(54) **RDS receiver.**

(57) An FM receiver for use in a Radio Data System (RDS), wherein a PTY (Program Type) code, M/S (Music/Speech Switch) code and DI (Decoder Identification) code are extracted from received RDS data, stored sound reproducing characteristic data, such as of tone quality, acoustic field and sound volume that correspond to the extracted codes are read from a data memory, and predetermined sound reproducing characteristic is then set automatically in accordance with the read-out sound reproducing characteristic data to provide the RDS receiver with the optimal condition in tone quality, acoustic field and sound volume for reproducing a high quality FM sound in view of the contents of a program and/or a mode of broadcasting.

F I G . 3

## BACKGROUND OF THE INVENTION

### 1. Field of the Invention

This invention relates to an FM receiver and, more particularly, to an FM receiver for use in a radio data system (hereinafter referred to as an RDS receiver).

### 2. Description of the Prior Art

The radio data system (RDS) is a kind of FM multiplex broadcasting system developed in European Broadcasting Union (EBU), wherein a frequency of 57 KHz which corresponds to the third harmonics of a main carrier wave of 19 KHz for an FM audio signal is adopted for a sub-carrier wave. This sub-carrier wave is then modulated by an RDS data signal, which is coded into a biphase code, in accordance with a carrier suppression amplitude modulation system. The amplitude-modulated sub-carrier is in turn superimposed on the frequency-modulated main carrier for broadcasting the RDS data, such as a program identification, alternative frequencies and the like, simultaneously with the FM audio signal in a multiplex broadcasting system.

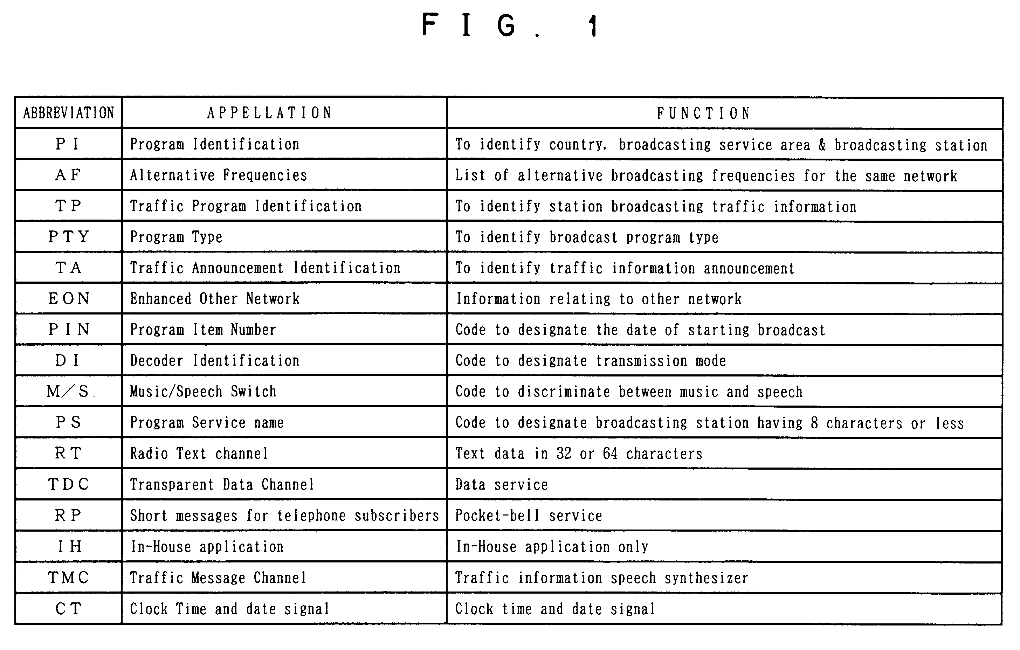

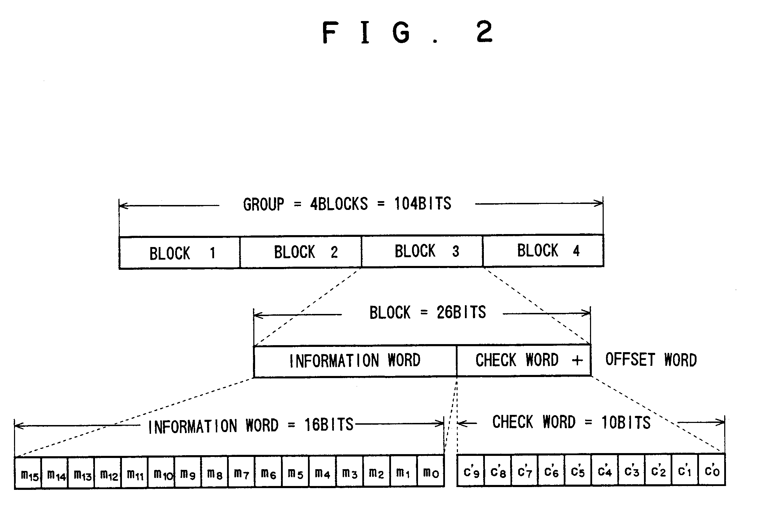

Referring to Figs. 1 and 2, there are shown a list of the RDS data and a transmission format thereof. The RDS receiver receives the RDS data broadcasted in accordance with the format of Fig. 2 and derives respective data of Fig. 1 from the received RDS data by decoding. In case of a vehicle-mounted RDS receiver, for example, if a motor-vehicle is leaving a service area of one broadcasting station and it becomes hard to receive the broadcast which has been listening, it may be possible to keep listening to the same program by switching over the broadcasting station to one after another automatically based on an alternative frequency list obtained from the received RDS data. In this way, it is possible to keep on listening to the same program regardless of broadcasting service areas.

On radio broadcasting, there are various programs such as of music, news, sports, traffic information, etc. Further, even in the music program, there are so many varieties such as classic music, jazz, light music and the like, and there are also many types of broadcasting in the music program, for example, a music program with a talk, commentary or the like. In view of a transmission mode of FM broadcasting, there are two different transmission modes such as a stereophonic broadcasting and monaural broadcasting.

To listen to the broadcast, selected are the most comfortable tone quality (frequency characteristic), acoustic field (such as surround effects), sound volume and the like depending on the contents of a selected program and/or transmission mode. Accordingly, to reproduce a high quality sound in the FM broadcast reception, the broadcasting system of which essentially has a high fidelity (Hi - I) characteristic, it is preferable to adjust the reproduced sound so as to have optimal values in tone quality, acoustic field and sound volume in response to a type of program, a mode of transmission and the like.

In case of listening to a classic music transmitted on stereophonic broadcast, it is preferable to set a radio receiver to have a flat frequency characteristic within the overall reproducible audio band width while to increase the sound volume slightly for eliminating insufficiency. Further, by setting the radio receiver to a surround mode which can provide echo effects like in a concert hall, it is possible to reproduce a music sound with a sense of immediacy.

In case of listening to a news program, it is preferable to turn off the surround mode in order to make it easier to catch announcer's voice. Further, by setting the frequency characteristic to locate vocal sounds at the central part of the reproducible audio band and that to locate a sound localization in the acoustic field at the front of the user, it is possible to reproduce the announcer's voice more clearly as directing the driver's attention concurrently toward the front. Heretofore, however, there has been no FM receiver which is capable of varying a condition of reproducing sound automatically in response to the contents of the program in reception, the transmission mode and the like, and the FM receiver has been set manually by the user whenever it has become necessary.

It is therefore an object of this invention to eliminate the problems encountered by the prior art FM receivers and to provide an RDS receiver wherein predetermined sound reproducing characteristics, such as a tone quality, acoustic field, sound volume and the like, of a reproducing FM sound are automatically selected to set a receiving condition optimal for receiving respective programs by making use of a PTY (Program Type) code, M/S (Music/Speech Switch) code, and DI (Decoder Identification) code contained in RDS data.

## SUMMARY OF THE INVENTION

An RDS receiver of the present invention comprises a sound reproducing characteristic data memory for storing predetermined sound reproducing characteristic data corresponding to a PTY (Program Type) code, M/S (Music/Speech Switch) code, and DI (Decoder Identification) code contained in RDS data, an extractor for extracting the PTY code, M/S code and DI code from the RDS data, a reader for reading the sound reproducing characteristic data that correspond to the extracted PTY code, M/S code and DI code from the data memory, and a controller for controlling the sound reproducing characteristics of an FM sound in accordance with the read-out sound reproducing characteristic data.

The predetermined sound reproducing characteristic data such as the tone quality, acoustic field and sound volume corresponding to the contents of program and/or the transmission mode are stored preliminarily in the sound reproducing characteristic data memory. Upon extracting the PTY code, M/S code and DI code from the RDS data contained in the FM radio wave presently in reception, the sound reproducing characteristic data reader reads the required sound reproducing characteristic data that correspond to the codes extracted from the sound reproducing characteristic data memory.

The PTY code, M/S code and DI code are provided for discriminating the following subject matters:

PTY (Program Type) code: for discriminating between the contents of the broadcast in reception such as classic music, light music, jazz, news and sports.

M/S (Music/Speech Switch) code: for discriminating between the types of the broadcast in reception such as music and speech.

DI (Decoder Identification) code: for discriminating between the modes of the broadcast in reception such as stereophonic broadcast and monaural broadcast.

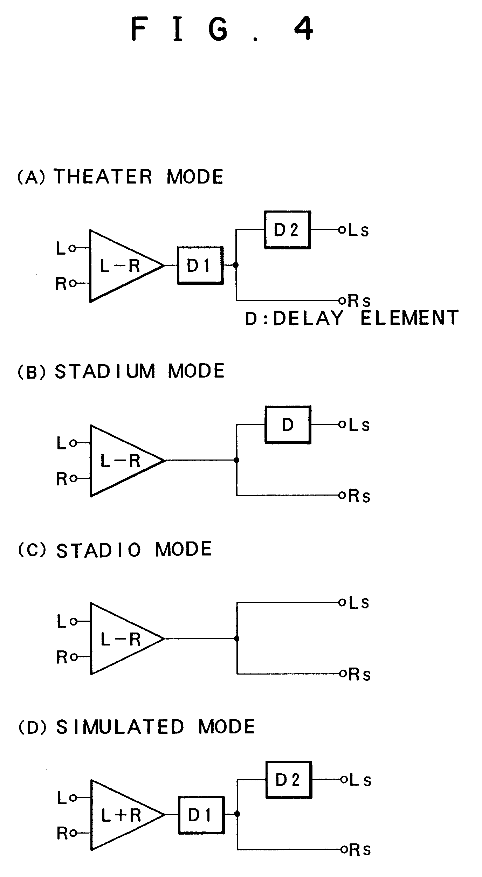

The sound reproducing condition controller controls the change-over of the predetermined sound reproducing characteristics such as the tone quality, acoustic field and sound volume in accordance with the read back sound reproducing characteristic data. That is, the tone quality can be changed by varying levels of respective frequency bands of an graphic equalizer and that the acoustic field can be varied by setting the FM receiver to either of the surround modes shown in Fig. 4. Further, the sound volume can be varied by controlling an electronic volume.

In this way, the predetermined sound reproducing characteristics such as the tone quality, acoustic field and sound volume in receiving the broadcast can be set automatically in accordance with the contents of the program and/or the mode of broadcasting. Accordingly, it is possible for the user to listen to the reproduced sound with optimal tone quality, acoustic field and sound volume relevant to the subject matter of the program in reception and/or the mode of broadcasting.

**BRIEF DESCRIPTION OF THE DRAWINGS**

Fig. 1 is a chart showing codes contained in an RDS data;

Fig. 2 is a diagram showing a transmission format of the RDS data;

Fig. 3 is a diagram showing an embodiment of this invention;

Fig. 4 is a circuit diagram showing a surround effects circuit for constituting an acoustic field control circuit; and

Fig. 5 is a flowchart showing operational steps to be implemented by the embodiment of Fig. 4 in the change-over of the sound reproducing characteristics.

**DETAILED DESCRIPTION OF THE PREFERRED EMBODIMENT**

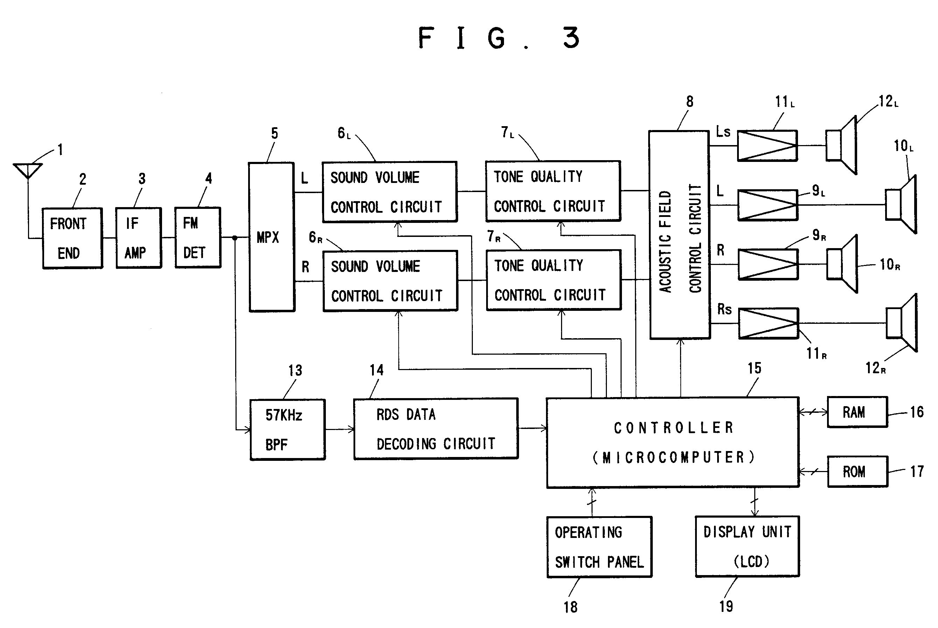

A preferred embodiment of this invention will now be described in detail by referring to the accompanying drawings. Referring to Fig. 3, there is shown a block diagram illustrating an RDS receiver embodying the present invention.

A desired broadcast wave is selected by a front end amongst FM multiplex broadcast waves received by an antenna 1. The selected broadcast wave is then fed to an FM discriminator 4 after being amplified at an IF amplifier 3. The front end 2 adopts, for example, a phase-locked loop (hereinafter referred to as "PLL") synthesizer system made up of a PLL circuit including a programmable frequency divider, a programmable dividing ratio of which is controlled by a controller 15 which will be described in detail hereinafter, for providing the tuning operation.

A discriminated output of the FM discriminator 4 is fed to a demultiplexer 5 for deriving an L (left) channel audio signal and R (right) channel audio signal therefrom in case of a stereophonic broadcasting. The L and R audio signals demodulated at the demultiplexer circuit 5 are then fed to an acoustic field control circuit 8 after being varied in sound volume and frequency characteristics through sound volume control circuits $6_L$ and $6_R$ such as of electronic volume controllers, and tone quality control circuits $7_L$ and $7_R$ such as of graphic equalizers. The acoustic field control circuit 8 consists, for example, of a surround circuit wherein a various kinds of surround modes can be selected as shown in Fig. 4. These sound volume control circuits $6_L$ and $6_R$, tone quality control circuits $7_L$ and $7_R$ and acoustic field control circuit are controlled by the controller 15 as hereinafter described in detail.

The front L and R audio signal outputs from the acoustic field control circuit 8 are fed to front L and R speakers $10_L$ and $10_R$ after being amplified by output amplifiers $9_L$ and $9_R$. Further, rear $L_s$ and $R_s$ signals are fed to L and R rear speakers $12_L$ and

$12_R$ after being amplified by output amplifiers $11_L$ and $11_R$.

On the other hand, the discriminated output of the FM discriminator 4 is also fed to a 57 KHz band-pass filter 13, whereby an amplitude-modulated sub-carrier wave or RDS data is extracted from the discriminated output, hence providing an RDS data decoding circuit 14 with the extracted RDS data.

The RDS data decoding circuit 14 decodes the RDS data fed through the 57KHz band-pass filter 13 for deriving the original RDS data. The decoded RDS data forms one group, as shown in Fig. 2, by coupling four blocks each of which has 26 bits, wherein discriminated are a start bit of the block and a position of which block in the group based on an off-set word of ten bits assigned for a check word of each block. Further, an error check for an information word of sixteen bits of the discriminated block is also implemented based on the check word. The decoded RDS data are fed to the controller 15.

The controller 15 consists of a microcomputer and receives coded information of each block of the RDS data, which is fed successively as a group unit, for storing it into a RAM 16. In addition to this, a dividing ratio of a programmable divider (not shown) of a PLL circuit, which forms a part of the front end 2, is controlled in response to FM station selecting commands input by utilizing an operating switch panel 18 for tuning in a desired FM station. Concurrently, a receiving frequency of the selected FM station is stored in the RAM 16.

Further, the controller 15 is provided with a display unit 19 such as a liquid crystal display unit for displaying necessary information such as a name of FM station, sound reproducing data such as the tone quality, acoustic field, sound volume and the like. Operating steps of the controller 15 will be implemented in accordance with a control program stored in a ROM 17.

The RAM 16 consists, for example, of a non-volatile memory unit of RAM and stores predetermined sound reproducing characteristic data prepared by the tone quality, acoustic field, sound volume and the like that correspond to a combination of the PTY (Program Type) code, M/S (Music/Speech Switch) code and DI (Decoder Identification) code. As for the tone quality data, for example, stored is a predetermined amount of setting level for each band after dividing an audio frequency band into seven bands. As for the acoustic field data, stored is data for determining whether to select one of the surround modes as shown in Fig. 4 or to cancel the surround mode. As for the sound volume data, stored are sound volume values (dB) to increase or decrease.

The sound reproducing characteristic data may be stored in the RAM 16 in many different ways. For example, the optimal sound reproducing characteristic data is manually set by the user at his discretion by utilizing the sound volume control circuits 6, tone quality control circuits 7 and acoustic field control circuit 8 for satisfying the user's preference. Further, in another way, standard sound reproducing characteristic data is stored in a ROM as default values when releasing from a factory, and is read from the ROM every time when the power is turned on for writing it into the RAM 16. It is also possible to employ a last position's memory system wherein the last set data is stored in the memory for the next operation whenever the sound reproducing characteristic is varied manually by the user while in listening to the broadcast.

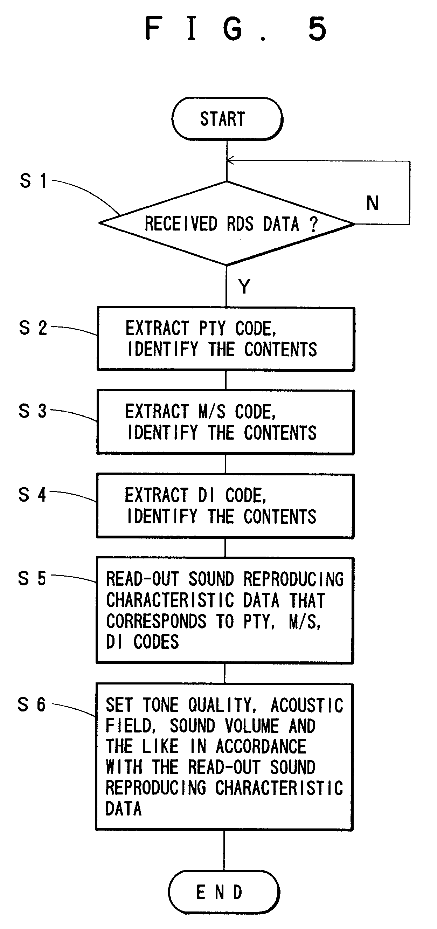

The automatic setting operation of the sound reproducing characteristics such as the tone quality, acoustic field and sound volume by making use of the RDS data will now be described by referring to a flowchart shown in Fig. 5.

Upon initiation of the operation, it is determined at step S1 whether or not the controller 15 receives RDS data. If it is, extracting a PTY code (step S2), M/S code (step S3) and DI code (step S4) from the received RDS data and discriminating a subject matter of each code at respective steps of S2, S3 and S4. Step S5 gives an access to a memory area of the RAM 16 wherein the sound reproducing characteristic data is stored by making use of a combination of the discriminated PTY code, M/S code and DI code as an address and reads the predetermined sound reproducing characteristic data, such as tone quality data, acoustic data and sound volume data, from the addressed memory area.

At step S6, the controller 15 controls the sound volume control circuits $6_L$ and $6_R$, tone quality control circuits $7_L$ and $7_R$ and acoustic field control circuit 8 to set the whole circuits for the optimal operating conditions in accordance with the read-out sound reproducing characteristic data.

More specifically, since the sound volume control circuits $6_L$ and $6_R$ consist of electronic sound volume controllers as described above, sound volume levels are increased or decreased respectively by a specific amount through the control of the electronic sound volume controllers in accordance with the read back sound reproducing characteristic data. Likewise, since the tone quality control circuits $7_L$ and $7_R$ consist of graphic equalizers, levels of divided frequency bands are set respectively to specific values in accordance with the read-out sound reproducing characteristic data so that a frequency characteristic of the reproduced sound has a required envelope. Further, since the acoustic field control circuit 8 consists of a surround circuit as described above, a desired acoustic field can be set by selecting either one of the surround modes shown in Fig. 4 in accordance with the read-out sound reproducing characteristic data or by canceling the surround mode.

After setting the tone quality, acoustic field and sound volume that correspond to the PTY code, M/S code and DI code contained in the received RDS data, output are FM sounds reproduced from respective speakers $10_L$, $10_R$, $12_L$ and $12_R$ in accordance with the sound reproducing characteristics being set. Accordingly, in accordance with the present invention, the sound reproducing characteristics of the FM receiver can be changed-over and set to the optimal condition automatically in accordance with the PTY code, M/S code and DI code contained in the received RDS data. Thus, it is possible to listen to an FM broadcast with the optimal sound reproducing characteristics in response to the contents of the program in reception or to the mode of broadcasting.

In the preferred embodiment as described above, the sound volumes were controlled only by utilizing the sound volume control circuits $6_L$ and $6_R$, however, it may be possible to provide a so-called fader control system, wherein a ratio of front and rear side sound volumes is varied through the simultaneous gain control of the output amplifiers $9_{L,R}$ and $11_{L,R}$.

Preferred setting examples of sound reproducing characteristics in accordance with the present invention will be shown in the followings:

1) For news and education program

Adjust the frequency characteristic to center on vocal frequencies and adjust the fader to localize the sound in front.

2) For stereophonic music program

Adjust the frequency characteristic (for example; a flat frequency characteristic) to match with an acoustic space (for example; an in-vehicle space) and set the surround effects to a studio mode of presence or theater mode depending on a class of music. Moreover, the sound volume may be increased slightly if it is required (for example; an extent of 3 dB).

3) For sports program

Adjust the frequency characteristic to match with the acoustic space and set the surround effects to a stadium mode emphasized in the spread of sound.

4) For monaural music program

Adjust the frequency characteristic to match with the acoustic space and set the surround effects to a simulated mode (a pseudo-stereophony).

As it is obvious from the description above, required sound reproducing characteristics for the RDS receiver, such as the tone quality, acoustic field and sound volume, can be set automatically to the optimal condition of reproducing sound in response to the contents of the receiving program or a type of transmission mode by making use of the PTY code, M/S code and DI code contained in the received RDS data.

Further, since the sound reproducing characteristics can be set automatically, it is no longer necessary to change the reproducing characteristics by consulting with a user's manual like used to, thus improving the operability of the FM receiver.

It is to be understood by those skilled in the art that the foregoing description relates only to a preferred embodiment of the invention and that various changes and modifications may be made in the invention without departing from the spirit and scope thereof.

## Claims

1. An RDS receiver comprising:

    memory means for storing predetermined sound reproducing characteristic data corresponding to a PTY (Program Type) code, M/S (Music/Speech Switch) code, and DI (Decoder Identification) code contained in RDS data;

    extractor means for extracting the PTY code, M/S code and DI code from the received and decoded RDS data;

    reader means for reading the sound reproducing characteristic data that correspond to the extracted PTY code, M/S code and DI code from said memory means; and

    control means for controlling sound reproducing characteristics of a reproducing FM sound in accordance with the read-out sound reproducing characteristic data.

2. An RDS receiver as defined in claim 1, further including display means coupled to said control means for displaying information relating to the sound reproducing characteristic data.

3. An RDS receiver as defined in claim 1, wherein said control means controls sound volume control circuits, tone quality control circuits and an acoustic field control circuit for controlling sound reproducing characteristics of a reproducing FM sound in accordance with the read-out sound reproducing characteristic data.

4. An RDS receiver as defined in claim 3, wherein said sound volume control circuits consist of a pair of electronic sound volume controllers.

5. An RDS receiver as defined in claim 3, wherein said tone quality control circuits consist of a pair of graphic equalizers.

6. An RDS receiver as defined in claim 3, wherein said acoustic field control circuit consists of a surround circuit which can select a plurality of surround modes.

# F I G . 1

| ABBREVIATION | APPELLATION | FUNCTION |
|---|---|---|
| P I | Program Identification | To identify country, broadcasting service area & broadcasting station |
| A F | Alternative Frequencies | List of alternative broadcasting frequencies for the same network |
| T P | Traffic Program Identification | To identify station broadcasting traffic information |
| P T Y | Program Type | To identify broadcast program type |
| T A | Traffic Announcement Identification | To identify traffic information announcement |
| E O N | Enhanced Other Network | Information relating to other network |
| P I N | Program Item Number | Code to designate the date of starting broadcast |
| D I | Decoder Identification | Code to designate transmission mode |
| M/S | Music/Speech Switch | Code to discriminate between music and speech |
| P S | Program Service name | Code to designate broadcasting station having 8 characters or less |
| R T | Radio Text channel | Text data in 32 or 64 characters |
| T D C | Transparent Data Channel | Data service |
| R P | Short messages for telephone subscribers | Pocket-bell service |
| I H | In-House application | In-House application only |
| T M C | Traffic Message Channel | Traffic information speech synthesizer |
| C T | Clock Time and date signal | Clock time and date signal |

EP 0 503 154 A2

# F I G . 2

GROUP = 4BLOCKS = 104BITS

| BLOCK 1 | BLOCK 2 | BLOCK 3 | BLOCK 4 |

BLOCK = 26BITS

| INFORMATION WORD | CHECK WORD + | OFFSET WORD |

INFORMATION WORD = 16BITS

CHECK WORD = 10BITS

| $m_{15}$ | $m_{14}$ | $m_{13}$ | $m_{12}$ | $m_{11}$ | $m_{10}$ | $m_9$ | $m_8$ | $m_7$ | $m_6$ | $m_5$ | $m_4$ | $m_3$ | $m_2$ | $m_1$ | $m_0$ |

| $c'_9$ | $c'_8$ | $c'_7$ | $c'_6$ | $c'_5$ | $c'_4$ | $c'_3$ | $c'_2$ | $c'_1$ | $c'_0$ |

EP 0 503 154 A2

EP 0 503 154 A2

# F I G . 4

## (A) THEATER MODE

D:DELAY ELEMENT

## (B) STADIUM MODE

## (C) STADIO MODE

## (D) SIMULATED MODE

# F I G .  5

```
                    ┌─────────┐
                    │  START  │
                    └─────────┘
                         │
                         ▼
S 1              ◇─────────────────◇      N
              ◇   RECEIVED RDS DATA ? ◇─────┐
                 ◇─────────────────◇        │
                         │ Y                 │
                         ▼                   │
S 2      ┌───────────────────────────┐      │
         │ EXTRACT PTY CODE,         │      │
         │ IDENTIFY THE CONTENTS     │      │
         └───────────────────────────┘      │
                         │                   │
                         ▼                   │
S 3      ┌───────────────────────────┐      │
         │ EXTRACT M/S CODE,         │      │
         │ IDENTIFY THE CONTENTS     │      │
         └───────────────────────────┘      │
                         │                   │
                         ▼                   │
S 4      ┌───────────────────────────┐      │
         │ EXTRACT DI CODE,          │      │
         │ IDENTIFY THE CONTENTS     │      │
         └───────────────────────────┘      │
                         │                   │
                         ▼                   │
S 5      ┌───────────────────────────┐      │
         │ READ-OUT SOUND REPRODUCING│      │
         │ CHARACTERISTIC DATA THAT  │      │
         │ CORRESPONDS TO PTY, M/S,  │      │
         │ DI CODES                  │      │
         └───────────────────────────┘      │
                         │                   │
                         ▼                   │
S 6      ┌───────────────────────────┐      │
         │ SET TONE QUALITY, ACOUSTIC│      │
         │ FIELD, SOUND VOLUME AND   │      │
         │ THE LIKE IN ACCORDANCE    │      │
         │ WITH THE READ-OUT SOUND   │      │
         │ REPRODUCING CHARACTERISTIC│      │
         │ DATA                      │      │
         └───────────────────────────┘      │
                         │                   │
                         ▼                   │
                    ┌─────────┐              │
                    │  E N D  │              │
                    └─────────┘              │
```